Europäisches Patentamt

European Patent Office

Office européen des brevets

(19)

(11) **EP 1 042 875 B1**

(12) ## EUROPEAN PATENT SPECIFICATION

(45) Date of publication and mention
of the grant of the patent:
**23.04.2003 Bulletin 2003/17**

(51) Int Cl.7: **H04B 10/155**

(86) International application number:
**PCT/DK98/00575**

(21) Application number: **98962299.8**

(22) Date of filing: **22.12.1998**

(87) International publication number:
**WO 99/034542 (08.07.1999 Gazette 1999/27)**

(54) **AN OPTICAL TRANSMITTER**

OPTISCHER SENDER

EMETTEUR OPTIQUE

(84) Designated Contracting States:
**DE FR GB IT**

(30) Priority: **23.12.1997 DK 152297**

(43) Date of publication of application:
**11.10.2000 Bulletin 2000/41**

(73) Proprietor: **TELLABS DENMARK A/S**
**2750 Ballerup (DK)**

(72) Inventor: **JENSEN, Niels, Anker**
**DK.-4000 Roskilde (DK)**

(74) Representative: **Boesen, Johnny Peder et al**
**Zacco Denmark A/S**
**Hans Bekkevolds Allé 7**
**2900 Hellerup (DK)**

(56) References cited:
**EP-A2- 0 221 710        GB-A- 2 258 753**

• **ELECTRONICS LETTERS, Volume 16, No. 1,**
**January 1980, F.S. CHEN, "Simultaneous**
**Feedback Control of Bias and Modulation**
**Currents for Injection Lasers".**

## Description

The present invention relates to an optical transmitter comprising a laser diode capable of emitting an optical signal in response to an electric current through the laser diode, said electric current consisting of a bias contribution and a modulation contribution provided by an information signal; a photodetector capable of detecting the optical signal and of emitting an electrical monitor signal in response to the optical signal; a first control loop adapted to control the size of the bias contribution of the electric current through the laser diode in response to the electrical monitor signal; a second control loop adapted to control the size of the modulation contribution of the electric current through the laser diode in response to the electrical monitor signal; said second control loop comprising a first transimpedance amplifier having a low input impedance, said electrical monitor signal being connected to an input on said transimpedance amplifier.

Laser transmitters are used in optical communications systems for converting an electrical information signal into an optical information signal which may be transferred from the laser transmitter to a receiver via a transmission connection. Laser diodes employed in laser transmitters for the transmission of digital signals are generally used for emitting an optical signal which switches between a high level and a low level as a consequence of modulation with a data signal. The data signal may then be extracted from the optical signal in a receiver. It is generally preferred to maintain a constant level for the optical output power, and the high and low levels of the optical signal at the receiver end should be separated by a suitable number of dB in order that the data signal may be extracted by the receiver.

The output power of the laser is controlled by controlling the current through the laser diode. It is well-known that the correlation curve between the laser diode and the output power is non-linear. This correlation curve is also called the characteristic of the laser diode and is reasonably approximated by a kink curve having a kink at the so-called threshold current of the laser diode. The characteristic of the laser diode, where the current is indicated along the x-axis and the optical output power along the y-axis, may be described as a first linear curve with a relatively small slope for currents through the laser diode smaller than the threshold current. For currents through the laser diode greater than the threshold current, the kink curve may be described as a second linear curve with a relatively great slope. The slope of the second part of the kink curve is generally called slope efficiency. As the laser diode does not emit a suitably narrow spectrum light signal, which means a pure laser signal, for currents through the laser diode smaller than the threshold current, it is preferred to control the laser diode with currents greater than the threshold current. If the current through the laser diode is smaller than the threshold current just for a relatively short time, it will take a relatively long time before the laser diode again emits a pure laser signal. When high frequency data signals are transmitted, the laser diode is therefore controlled with currents greater than the threshold current to avoid emitting a distorted optical signal because of this sluggishness or time delay.

When the parameters determining the kink curve have been determined, e.g. based on a measurement of associated values between current and optical output power of the laser, it is easy to design a control system which can supply the laser diode with suitable current levels. Suitable current levels mean levels where the high and low optical levels of the laser are separated as necessary, that is there is a suitable modulation depth, while the average level is kept at a desired value. More precisely, the modulation depth is defined as the relation between the powers which are emitted at a high level and a low level, respectively.

Semiconductor lasers, however, are characterized by being sensitive to ageing phenomena and temperature changes. The laser parameters, e.g. the values of the threshold current and the slope efficiency, may thus vary quite considerably.

It is well-known to compensate for temperature impacts on the laser by mounting the laser in connection with a thermoelement, e.g. a Peltier element, measuring the temperature of the laser and keeping it constant by respectively adding or removing thermal energy from the laser by means of the thermoelement. This solution, however, is inexpedient, as it is mechanically complicated to implement in equipment which must be capable of tolerating vibrations and the like. Furthermore, this solution requires some space in the physical structure.

Some types of semiconductor lasers are provided with a monitor diode in the form of a photodiode which can monitor the optical signal emitted from the laser diode. The monitor diode may be biased by a voltage in the reverse direction of the monitor diode so as to generate in the monitor diode a current, called the monitor current hereinafter, which is substantially proportional to the signal emitted by the laser diode. The monitor diode is characterized inter alia in that the size of the monitor current generated per amount of light is directly proportional to a current factor. To obtain a good sensitivity for the monitor diode it is desired that the bias is suitably great. Further, such monitor diodes have a given internal capacity which directly gives rise to a relatively small bandwidth for the monitor diode. However, it is so that this capacity is reduced by increased bias. Generally, it is therefore desired to apply a relatively great bias across the monitor diode.

The patent specifications US 5 153 765 and GB 2 258 753 disclose another solution in which this monitor diode is used. The solution is based on connecting the cathode of the monitor diode to an input on a transimpedance amplifier which has a low input impedance. The transimpedance amplifier has an output where an output voltage proportional to the optical output signal of the laser diode may be measured. Moreover, the data signal to be emitted by the laser signal is superimposed by a pilot tone signal. Thus, the output signal from the transimpedance amplifier includes a contribution which correlates with the pilot tone signal. This contribution is detected via the transimpedance amplifier and a band-pass filter. The contribution is incorporated in the control of the modulation depth of the optical signal from the laser diode by means of a control loop. The mean value of the optical output signal of the laser diode is detected by means of the transimpedance amplifier and a low-pass filter which is incorporated in the control of the size of a bias contribution to the laser diode, so that the laser diode is controlled with currents greater than the threshold value.

This solution has the serious drawback that the pilot tone signal superimposed on the optical output signal from the laser transmitter may cause erroneous detection of the data signal in a receiver or cause problems elsewhere in the communications system. This will be particularly probable if the data signal, just for periods, has a spectral component at the pilot tone frequency, since a spectral component will hereby be formed at the pilot tone frequency having a size that may cause unpredictable disturbances of the transmission and detection of the data signal. Further, this solution requires respective filters which are incorporated in the control of the mean value and modulation depth of the optical output signal. The solution will thus require relatively complicated sub-circuits and even take up a good deal of space in a physical circuit.

A third well-known solution of compensating temperature impacts on the laser is based on connecting the cathode of the monitor diode to a voltage potential, e.g. a supply voltage, via an external resistor. The current running in the monitor diode thus gives rise to a voltage, which can be detected, across the external resistor. This voltage is used as a sensor signal for a control loop capable of controlling the mean value of the current through the laser and thereby the mean value of the optical output signal. This solution, however, is inexpedient, as the external resistance will have a certain stray capacity that will decouple part of the AC component of the monitor signal. This will limit the overall bandwidth of resistor and monitor diode. The solution therefore only lends itself for the detection of relatively low frequency components in the monitor signal and thus just gives rise to control of the mean value of the optical output signal of the laser in a high speed optical transmitter.

Below the monitor current is assumed to have an AC component and a DC component, the DC component being taken to mean a relatively slowly varying or constant signal which contains information on the mean value of the optical output power of the laser diode, the AC component being taken to mean a relatively rapidly varying signal which contains information on the modulation depth.

Accordingly, an object of the invention is to enable detection of the monitor signal so that the DC component may be detected simultaneously and independently of the AC component, thereby allowing these components to be used in a simple manner as sensor signals in respective control loops capable of compensating for drift of the parameters of the laser.

This is achieved when the first control loop comprises a current-controlled source and a first current source, and when the electrical monitor signal is connected to an input on this current-controlled source, and wherein said first current source is controlled by an output signal from said current controlled source.

It is hereby ensured that both the mean value and the modulation depth of the optical signal emitted from the laser diode are kept constant independently of each other. This solution is simple to provide, as the AC and DC components of the monitor signal are detected separately and thereby reduce the complexity of the complete circuit. Moreover, this solution only requires little space in a physical circuit.

In a preferred embodiment, the current-controlled source is a current-controlled current source. This is particularly expedient, since it provides a signal which may be compared directly with the monitor signal.

In a particular, preferred embodiment, the current-controlled current source is a current mirror. This is particularly expedient, as the current mirror has a relatively low bandwidth and thereby automatically filters higher frequencies from the reflected monitor signal.

With a view to maintaining a constant and sufficiently great bias across the monitor diode, the first transimpedance amplifier has an input stage of earthed emitter type in a preferred embodiment. It is hereby ensured that the monitor diode is loaded by a low impedance, it being simultaneously possible to establish a constant and sufficiently great bias across the monitor diode, thereby achieving a great bandwidth.

In a particular embodiment, it is expedient that the first control loop comprises a second transimpedance amplifier, connected to receive a current signal proportional to the electrical monitor signal by means of the current-controlled current source. The current signal from the current source may hereby be converted into a voltage.

A simple control of the optical mean output power of the laser diode is obtained in a preferred embodiment, if the first control loop additionally comprises a regulator connected to receive a signal from said transimpedance amplifier and to emit a bias control signal which may be used for controlling said laser diode.

To obtain a stable signal capable of representing the modulation depth in the optical signal, it is preferred that the second control loop comprises a peak-to-peak value detector connected to receive a signal from said first transimpedance amplifier. This generates a signal capable of representing the modulation depth in the optical signal irrespective of which duty cycle a modulation signal in question has.

A simple control of the optical modulation depth of the laser diode is obtained in a preferred embodiment in that the second control loop additionally comprises a regulator connected to receive a signal from said peak-to-peak value detector and to emit a modulation control signal which may be used for controlling said laser diode.

In a special embodiment, the current-controlled source is a current-controlled voltage source, which ensures that the electrical monitor signal is converted into a voltage which may be used as an input signal for a regulator.

The invention will now be explained with reference to the drawing, in which

fig. 1 shows a block diagram of a preferred embodiment of the invention;

fig. 2 shows the optical output power of a laser diode as a function of the current through the laser diode and the temperature of the laser diode when this is not temperature-regulated and is provided with a variable pulse current according to the invention;

fig. 3 shows a current mirror;

fig. 4 shows a transimpedance amplifier with earthed emitter input stage;

fig. 5 shows a controlled current source; and

fig. 6 shows the optical output power of a laser diode as a function of the current through the laser diode and the temperature of the laser diode when this is not temperature-regulated and is provided with a constant pulse current.

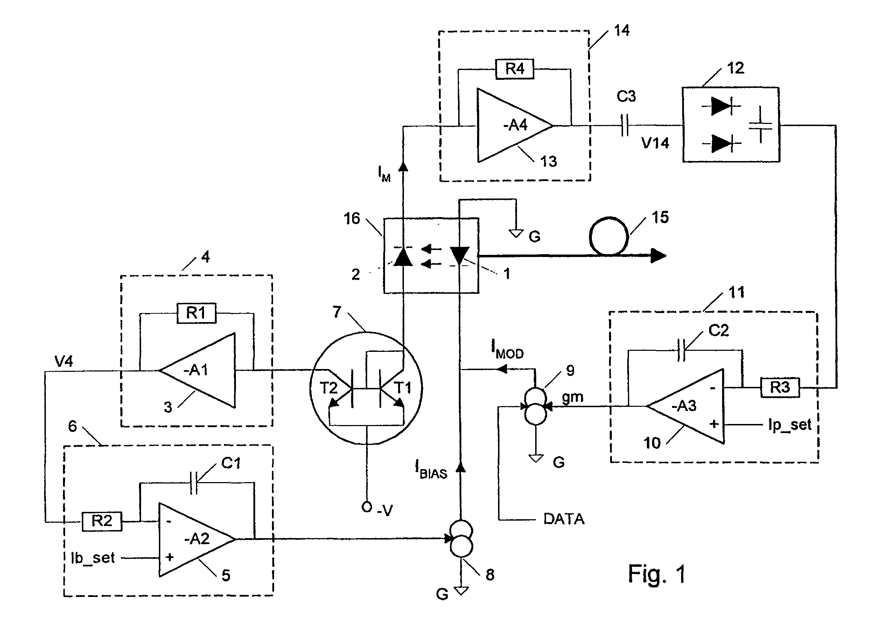

Fig. 1 shows a block diagram of a preferred embodiment of the invention which incorporates a laser diode 1 capable of emitting light on which a communications signal is modulated, and a photodiode 2 which is used as a monitor diode, i.e. for monitoring the light emitted by the laser diode. The purpose of the photodiode is to enable regulation of the light emitted from the laser diode. The block diagram comprises a first control loop which keeps the mean value of the optical signal constant, and a second control loop which keeps the modulation depth constant. The control loops extract relatively low frequency mean value information and relatively high frequency pulse information from the optical signal by means of the monitor diode 2 via a so-called current mirror 7 and a transimpedance amplifier 14, respectively.

The laser diode 1 is mounted such that it can emit light through an optical fibre 15, and such that the monitor diode 2 can detect an optical signal corresponding to the signal which is emitted through the optical fibre 15. The laser diode 1 and the monitor diode 2 are typically mounted in the same housing 16, e.g. in a housing of the dual inline (DIL) type. The monitor diode 2 may be considered as a current generator which is loaded by two circuits, viz. the transimpedance amplifier 14 and the current mirror 7 consisting of the transistors T1 and T2. When the monitor diode is loaded in this manner according to the invention, it is ensured that high and low frequency components from the current generator, in the form of the monitor diode 2, may be detected separately and thereby simplify the following signal processing.

The control loop keeping the mean value of the optical output signal of the laser constant will be described below. The anode of the monitor diode is connected to the collector and the base of the transistor T1. The base of T1 is connected to the base of T2, and the emitter of T2 is connected to the emitter of T1. Furthermore, the thus common emitter is connected to a suitable negative supply voltage -V, e.g. -5 volts, relative to a common reference G. This takes place in practice through a series resistor with an ohmic resistance of e. g. 200 ohms. The current mirror 7 hereby contributes to the bias of the monitor diode 2, as the anode of the monitor diode has applied to it a voltage potential on the negative supply voltage plus the base emitter voltage drop across T1. The coupling of T1 and T2 thus keeps a voltage potential of about -4.3 volts on the anode of the monitor diode if -V is -5V.

It should be noted here that such a coupling has a relatively low bandwidth with respect to the bandwidth that can be detected by the monitor diode. With this limited bandwidth, the current from the monitor diode is reflected to a collector current in the transistor T2. Thus, with a suitable bias, the size of the current $I_M$ running through the monitor diode will correspond to the size of the current running through the collector of T2, and the coupling is therefore also called a current mirror.

The collector of T2 is connected to a transimpedance amplifier 4 consisting of an operational amplifier 3 with a gain -A1 and a feedback resistor R1. The voltage V4 on the output of the transimpedance amplifier is thus

$$V4 = -R1\, I_M,$$

it being assumed that the input impedance of the operational amplifier is great. The output of the transimpedance amplifier 4 is connected to a regulator 6 consisting of R2, C1 and the operational amplifier 5 with the gain A2. The operational amplifier 5 has an inverting input (-) and a non-inverting input (+). The output of the transimpedance amplifier 4 is connected to the inverting input (-) on the operational amplifier 5 via the resistor R2 and therefore constitutes a sensor signal for the regulator 6. The operational amplifier 5 is fed back by means of the capacitor C1, which is connected from the output of the operational amplifier to the inverting input (-). A reference value Ib_set corresponding to a desired optical mean value may be set on the non-inverting input (+). The regulator 6 hereby forms a control signal which is applied to a voltage-controlled current source 8 connected to the cathode of the laser diode 1 and the common reference G. The voltage-controlled current source 8 thereby generates a current contribution $I_{BIAS}$ to control the laser diode 1. The anode of the laser diode is connected to the common reference G, the potential of G being defined to be 0 volt.

The control loop consisting of the monitor diode 2, the current mirror 7, the transimpedance amplifier 4, the regulator 6, the controlled current source 8 and the laser diode 1 thus makes it possible to keep the mean value of the current through the laser diode constant below a given bandwidth of the loop. The optical mean output power of the laser diode is thereby regulated by a regulator in the form of the regulator 6.

The control loop keeping the modulation depth of the optical output signal of the laser constant will be described below. With a view to detecting the size of the optical signals (pulses) which the laser diode 1 emits because it is modulated with an information signal DATA, the cathode of the monitor diode is connected to the input of a transimpedance amplifier 14. The output of the transimpedance amplifier 14 is connected to a peak-to-peak value detector 12 via a capacitor C3 which serves as a DC shut-off.

As the laser diode is modulated at relatively high frequencies, it is necessary that the transimpedance amplifier 14 and the peak-to-peak detector 12 can keep step at these relatively high frequencies. The transimpedance amplifier 14 consists of the amplifier 13 with a gain -A4 and a feedback resistor R4. The voltage $V14_{AC}$ between the capacitor C3 and the peak-to-peak value detector 12 is thus

$$V14_{AC} = -R4\ I_M$$

assuming that the input impedance of the operational amplifier is great. When the gain in the amplifier 13 is great, the input impedance $R_{in}$ of the transimpedance amplifier 14 may be approximated as

$$R_{in} = R4/A4.$$

This quantity will typically be small; that is it may be made less than 10 ohms in practice. The monitor diode is hereby loaded by a small impedance, and this therefore does not give rise to a significant reduction in bandwidth. A particularly expedient transimpedance amplifier may be constructed with an earthed emitter input stage. It is hereby ensured that the monitor diode 2 is loaded by a small impedance, while having a constant and suitably high bias, as the DC voltage potential on the input of this transimpedance amplifier corresponds to a base emitter voltage drop. This will be explained later. It is thus possible to detect relatively high frequencies with the monitor diode 2, as the internal capacity of the monitor diode is reduced by the suitably high bias.

With a view to modifying the electrical signal with which the laser 1 is modulated, it is just the AC variation in the signal detected by the monitor diode that is interesting. This variation is extracted by means of the DC shut-off in the form of the capacitor C3 and the peak-to-peak value detector 12. The output of the peak-to-peak value detector 12 is connected to a regulator 11 consisting of R3, C2 and the operational amplifier 10 with the gain A3. The operational amplifier 10 has an inverting input (-) and a non-inverting input (+). The inverting input is connected to the output of the peak-to-peak value detector via the resistor R3. The operational amplifier 10 is fed back by means of the capacitor C2 which is connected from the output of the operational amplifier to the inverting input (-). A reference value corresponding to a desired pulse current caused by a modulation signal may be set on the non-inverting input (+). The regulator 11 thereby forms a control signal gm which is applied to a voltage-controlled current source 9. The current source 9 may additionally be modulated by a data signal DATA. The current source is connected to the cathode on the laser diode 1 and the common reference G and contributes with a current $I_{MOD}$ to control the laser diode 1.

The total current through the laser diode 1 thus consists of a contribution from the control loop which maintains the optical mean output power, and by a contribution from the control loop which maintains the modulation depth, that is $I_{BIAS}$ plus $I_{MOD}$.

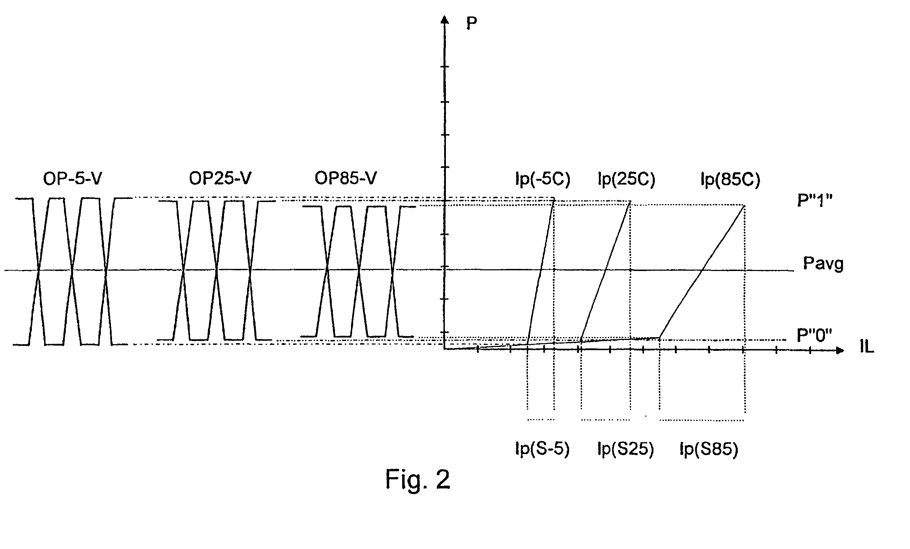

Fig. 2 shows the optical output power P for a laser diode as a function of the current through the laser diode IL and the temperature of the laser diode when it is not temperature-regulated and is provided with a variable pulse current according to the invention. The curves Ip(-5C), Ip(+25C) and Ip(+85C) are plotted for a laser diode at the temperatures -5 °C, +25 °C and +85 °C, controlled by a circuit according to the invention, e. g. the circuit shown in fig. 1. The laser diode is thereby present in a closed loop control system, in which both the mean value of the optical signal from the laser diode and the modulation depth are kept constant. A bias current Ib_set for the laser diode 1 is set so as to achieve a desired optical mean value Pavg. Then a pulse current Ip_set is set so that an expected maximum level for the optical output power P"1" may be realized, and so that an expected minimum level for the optical output power P"0" may be realized. The pulse current Ip(S) thereby caused by a data signal DATA gives a suitable modulation depth. This is illustrated by the optical signals OP-5-V, OP25-V and OP85-V which have substantially the same mean value Pavg and a modulation depth close to the maximum depth.

At the temperature 85 °C the slope efficiency S of the laser diode has dropped considerably relative to the situation at 25 °C. To maintain a constant modulation depth in the optical signal, the pulse current is therefore increased from Ip(S25) to Ip(S85).

At the temperature -5 °C the slope efficiency S of the laser diode has correspondingly increased considerably relative to the situation at 25 °C. To maintain a constant modulation depth in the optical signal, the pulse current is reduced from Ip(S25) to Ip(S-5).

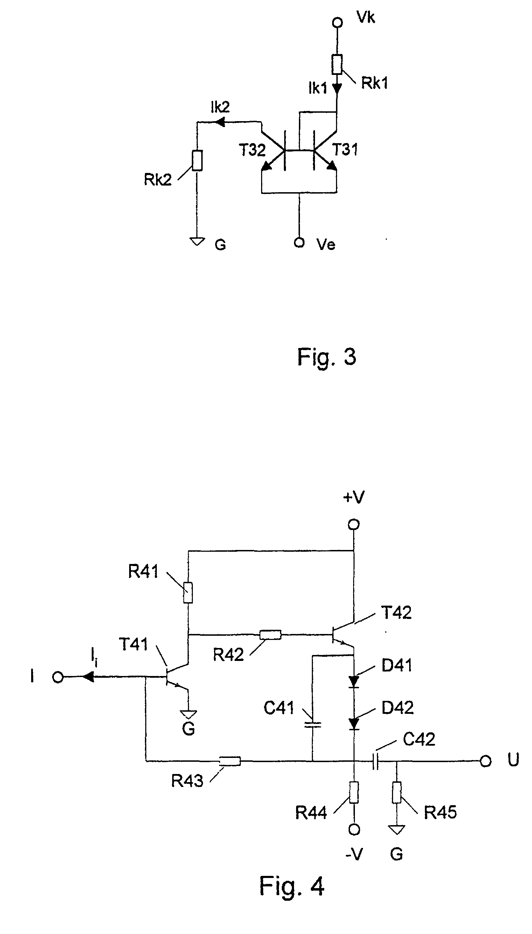

Fig. 3 shows a current mirror. The current mirror consists of two bipolar transistors T31 and T32, each of which has base, emitter and collector terminals. The base of T31 is connected to the base of T32, and the emitter of T31 is connected to the emitter of T32. The thus common base terminal is connected to the collector of T31, which is also connected to a supply voltage Vk via a resistor Rk1. The common emitter terminal is connected to a suitable supply voltage Ve so as to create a base emitter voltage across the transistor T31 and so as to allow a current Ik1 to run. Compared with the current mirror in fig. 1, Ik1 corresponds to the current through the monitor diode. Because of the short-circuit of base and emitter on T31, T31 is in a so-called saturated state and operates as a diode. The collector of the transistor T32 is connected to a load resistor Rk2 through which a current Ik2 substantially equal to the current Ik1 will run. If bf is the current gain of the transistors, Ik2 may be written as a function of Ik1:

$$Ik2 = bf/(2+bf)Ik1$$

which applies approximately to bf >> 1 and for relatively low frequencies, as the current transfer function Ik2/Ik1 for the connection of T31 and T32 has a relatively low bandwidth.

The current mirror in fig. 3 may alternatively be replaced by a so-called Widlar current source, a Wilson circuit, a cascade current source or other alternatives, which have the feature that an input current is converted into an output current or voltage, optionally with a certain bias, and with a relatively low bandwidth.

Fig. 4 shows a transimpedance amplifier with an earthed emitter input stage. The transimpedance amplifier is composed of a voltage-amplifying stage consisting of T41 and R41, connected to a current-amplifying stage in the form of T42 via the resistor R42. The transimpedance amplifier is negatively fed back with a current feedback in the form of the resistor R43.

The input signal to the amplifier is in the form of a current $I_i$ which runs via the input terminal I. With the reasonable assumption that the part of the current $I_i$ running through the resistor R43 is much greater than the current running into the base of T41, the gain of the transimpedance amplifier is essentially determined by R43. The part of the output voltage which originates from the input current $I_i$ may thus be determined as $I_i$ multiplied by the ohmic value of R43. R43 is therefore also called the transimpedance.

The diodes D41 and D42 contribute together with the base emitter voltage drop in T42 to establishing a suitable working point for T41. The capacitor C41 operates as a high frequency short-circuit of the diodes. The resistor R44 contributes to establishing a working point for the transistor T42. The capacitor C42 operates as a DC shut-off, and the resistor R45 merely operates as a load resistor.

**[0043]** - V, +V and G respectively signify a negative supply voltage, a positive supply voltage and a common earth potential which is defined to be 0 volt.

The AC variation of the input current signal $I_i$ is thus converted into a voltage which may be measured on the output terminal U.

This amplifier is preferred, as it has a low input impedance and thus makes it possible to detect relatively high frequencies in combination with the monitor diode 2 in fig. 1.

This transimpedance amplifier is moreover preferred in combination with the current mirror 7 in fig. 1, as the voltage drop occurring across the base emitter junction in T41 compensates the voltage drop which occurs across the base emitter junction in T1 in fig. 1, and the monitor diode 2 may thereby be biased by a full voltage supply -V.

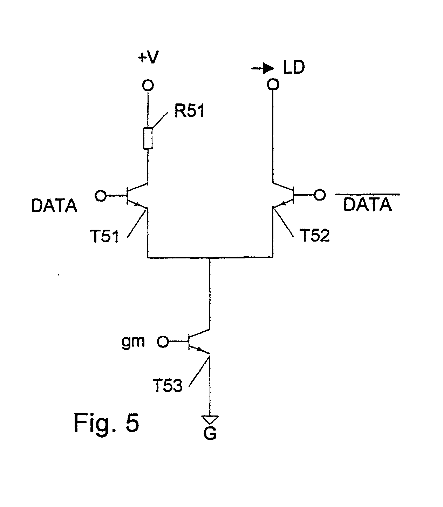

Fig. 5 shows a controlled current source. The shown current source is a preferred and more detailed embodiment of the controlled current source 9 in fig. 1. The current-controlled source is built as a differential stage consisting of T51 and T52 with a bias circuit in the form of T53. T51 and T52 are connected to receive the signal DATA and a negated version $\overline{DATA}$ of the signal DATA, respectively, which are signals with the logic levels "1" and "0". The collector of T51 is connected to the supply voltage +V via the resistor R51. The collector of T52 is connected to the cathode of the laser diode 1 in fig. 1 to contribute with the modulation current IMOD. The transconductance of the differential connection of T51 and T52 is controlled by the signal gm via the transistor T53.

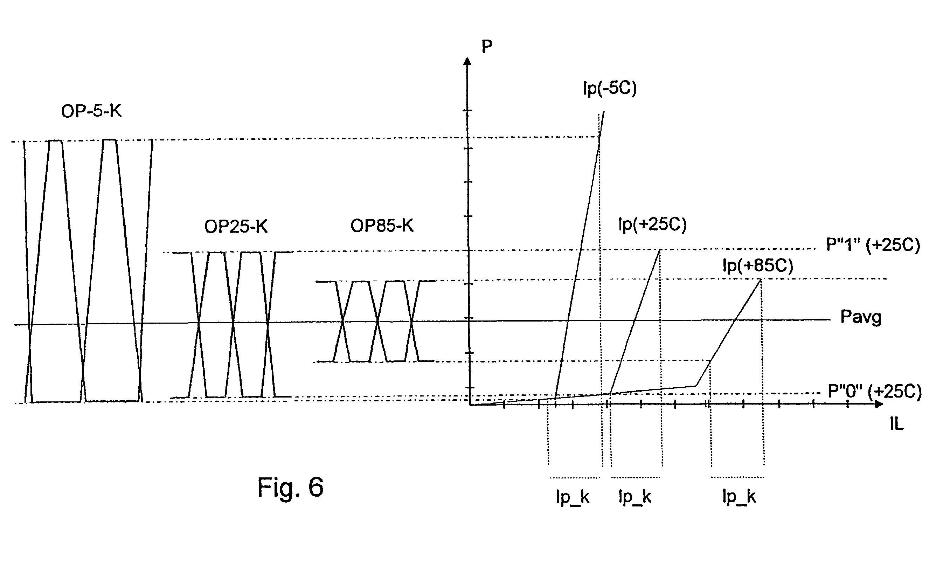

Fig. 6 shows optical output power for a laser diode as a function of the current through the laser diode and the temperature of the laser diode when it is not temperature-compensated and is provided with a constant pulse current. This corresponds to controlling the laser diode as indicated by the circuit in fig. 1, but with the control loop comprising the transimpedance amplifier 14 interrupted so that the current $I_{MOD}$ just depends on the signal DATA.

The curves Ip(-5C), Ip(+25C) and Ip(+85C) are plotted at the temperatures -5 °C, +25 °C and +85 °C. The control system is now arranged such that a desired bias current Ib_set may be set for the laser diode by means of the control loop. The bias current $I_{BIAS}$ to the laser diode is regulated in response to the optical output power of the laser diode, so that the output power is kept constant. The laser diode may be modulated with a data signal consisting of logic 1s and 0s in the form of a sequence of electrical pulses with a given amplitude. The control system is an open loop system in the sense that there is no coupling from the optical power, which is emitted by the laser diode, to the modulation to which it is subjected, that is to the amplitude of the electrical pulses.

The three curves Ip(-5C), Ip(+25C) and Ip(+85C) indicate how the laser diode changes characteristic in response to the temperature. The sharp kinks on the curves indicate the threshold value of the laser diode for a given temperature. When a current greater than the threshold value runs through the laser diode at a given temperature, stimulated emission is radiated, and the laser diode thereby operates as a laser. Below the threshold value, the laser diode radiates spontaneous emission and thereby operates almost as a light-emitting diode.

For most communications purposes it is the effect of the laser diode as a laser which is interesting, and the laser diode is therefore modulated in the range in which it operates as a laser, that is it is controlled by a current greater than the threshold current. For currents through the laser diode greater than the threshold value, there is an approximately linear relation between diode current and optical output power. This relation is called the slope efficiency, S, of the laser diode. The slope efficiency, like the threshold value, is greatly dependent on the temperature of the laser diode. In practice, the slope efficiency may vary by more than a factor of 2. This can be seen from the figure, as the slope of the three curves in the "laser range" is different. The control loop for the bias current is set so that the laser diode emits a selected optical mean power, Pavg. The amplitude of the modulation signal is selected so as to achieve a maximum modulation depth, without the output signal being distorted.

The optical signal OP25-K corresponding to said setting procedure at the temperature 25 °C is undistorted and simultaneously has a maximum modulation depth. This, however, will change when the temperature increases and decreases, respectively. At the temperature +85 °C the slope efficiency of the laser diode has become so poor that the control system must increase the bias current strongly to maintain a given optical mean power. This great bias current causes the corresponding optical signal OP85-K to have a considerable DC component. This DC component together with a poor modulation depth diminishes the possibility of detecting the data signal transmitted by the transmitter without error in a receiver.

At the temperature -5 °C the slope efficiency of the laser diode has increased on the other hand, and the threshold value has dropped, so that the modulation signal gives rise to a strong distortion of the optical signal OP-5-K.

Although a preferred embodiment of the present invention has been described and shown, the invention is not restricted to it, but may also be embodied in other ways within the subject-matter defined in the following claims.

**Claims**

1. An optical transmitter comprising

   • a laser diode (1) capable of emitting an optical signal in response to an electric current through the laser diode, said electric current consisting of a bias contribution and a modulation contribution provided by an information signal;
   • a photodetector (2) capable of detecting the optical signal and emitting an electrical monitor signal in response to the optical signal;
   • a first control loop adapted to control the size of the bias contribution of the electric current through the laser diode in response to the electrical monitor signal by means of a first current source (8) controlled by said electrical monitor signal;
   • a second control loop adapted to control the size of the modulation contribution of the electric current through the laser diode in response to the electrical monitor signal; said second control loop comprising a first amplifier (14), said electrical monitor signal being connected to an input of said amplifier;

   **characterized in that**

   • the first amplifier (14) is a transimpedance amplifier having a low input impedance;
   • the first control loop further comprises a current-controlled source (7) having an input connected to the electrical monitor signal; and
   • said first current source (8) is arranged to- be controlled by an output signal from the current-controlled source (7).

2. A laser transmitter according to claim 1, **characterized in that** the current-controlled source (7) is a current-controlled current source.

3. A laser transmitter according to claim 2, **characterized in that** the current-controlled current source (7) is a current mirror.

4. A laser transmitter according to claim 1, **characterized in that** the first transimpedance amplifier (14) has an input stage of earthed emitter type.

5. A laser transmitter according to claims 1-4, **characterized in that** the first control loop comprises a second transimpedance amplifier (4) connected to receive a current signal proportional to the electrical monitor signal by means of the current-controlled current source (7).

6. A laser transmitter according to claim 5, **characterized in that** the first control loop additionally comprises.a regulator (6) connected to receive a signal from said first transimpedance amplifier and to emit a bias control signal which may be used for controlling said laser diode.

7. A laser transmitter according to claims 1-6, **characterized in that** the second control loop comprises a peak-to-peak value detector (12) connected to receive a signal from said first transimpedance amplifier.

8. A laser transmitter according to claim 7, **characterized in that** the second control loop additionally comprises a regulator (14) connected to receive a signal from said peak-to-peak value detector and to emit a modulation control signal which may be used for controlling said laser diode.

9. A laser transmitter according to claim 1, **characterized in that** the current-controlled source is a current-controlled voltage source.

**Patentansprüche**

1. Optischer Sender, umfassend

- eine Laserdiode (1), die ein optisches Signal als Reaktion auf einen elektrischen Strom durch die Laserdiode emittieren kann, wobei der elektrische Strom aus einem Vorspannungsbeitrag und einem durch ein Informationssignal gelieferten Modulationsbeitrag besteht;
- einen Fotodetektor (2), der das optische Signal detektieren und ein elektrisches Überwachungssignal als Reaktion auf das optische Signal emittieren kann;
- einen ersten Regelkreis, der so angepasst ist, dass er die Größe des Vorspannungsbeitrags des elektrischen Stroms durch die Laserdiode als Reaktion auf das elektrische Überwachungssignal mittels einer durch das elektrische Überwachungssignal gesteuerten ersten Stromquelle (8) steuert;
- einen zweiten Regelkreis, der so angepasst ist, dass er die Größe des Modulationsbeitrags des elektrischen Stroms durch die Laserdiode als Reaktion auf das elektrische Überwachungssignal steuert; wobei der zweite Regelkreis einen ersten Verstärker (14) umfasst, wobei das elektrische Überwachungssignal mit einem Eingang des Verstärkers verbunden ist;

**dadurch gekennzeichnet, dass**

- der erste Verstärker (14) ein Transimpedanzverstärker mit einer niedrigen Eingangsimpedanz ist;
- der erste Regelkreis weiter eine stromgesteuerte Quelle (7) mit einem Eingang, der mit dem elektrischen Überwachungssignal verbunden ist, umfasst; und
- die erste Stromquelle (8) so angeordnet ist, dass sie durch ein Ausgangssignal von der stromgesteuerten Quelle (7) gesteuert wird.

2. Lasersender nach Anspruch 1, **dadurch gekennzeichnet, dass** die stromgesteuerte Quelle (7) eine stromgesteuerte Stromquelle ist.

3. Lasersender nach Anspruch 2, **dadurch gekennzeichnet, dass** die stromgesteuerte Stromquelle (7) ein Stromspiegel ist.

4. Lasersender nach Anspruch 1, **dadurch gekennzeichnet, dass** der erste Transimpedanzverstärker (14) eine Eingangsstufe vom geerdeten Emittertyp aufweist.

5. Lasersender nach den Ansprüchen 1-4, **dadurch gekennzeichnet, dass** der erste Regelkreis einen zweiten Transimpedanzverstärker (4) umfasst, der so verbunden ist, dass er ein zum elektrischen Überwachungssignal proportionales Stromsignal mittels der stromgesteuerten Stromquelle (7) empfängt.

6. Lasersender nach Anspruch 5, **dadurch gekennzeichnet, dass** der erste Regelkreis zusätzlich einen Regler (6) umfasst, der so verbunden ist, dass er ein Signal von dem ersten Transimpedanzverstärker empfängt und ein Vorspannungssteuersignal emittiert, das zum Steuern der Laserdiode verwendet werden kann.

7. Lasersender nach den Ansprüchen 1-6, **dadurch gekennzeichnet, dass** der zweite Regelkreis einen Spitze-Spitze-Wert-Detektor (12) umfasst, der so verbunden ist, dass er ein Signal von dem ersten Transimpedanzverstärker empfängt.

8. Lasersender nach Anspruch 7, **dadurch gekennzeichnet, dass** der zweite Regelkreis zusätzlich einen Regler (14) umfasst, der so verbunden ist, dass er ein Signal von dem Spitze-Spitze-Wert-Detektor empfängt und ein Modulationssteuersignal emittiert, das zur Steuerung der Laserdiode verwendet werden kann.

9. Lasersender nach Anspruch 1, **dadurch gekennzeichnet, dass** die stromgesteuerte Quelle eine stromgesteuerte Spannungsquelle ist.

**Revendications**

1. Emetteur optique comprenant

   • une diode laser (1) capable d'émettre un signal optique en réponse à un courant électrique à travers la diode laser, ledit courant électrique étant constitué d'une contribution de polarisation et d'une contribution de modulation fournies par un signal d'information ;
   • un photodétecteur (2) capable de détecter le signal optique et d'émettre un signal de moniteur électrique en réponse au signal optique ;
   • une première boucle de commande adaptée pour commander la taille de la contribution de polarisation du courant électrique à travers la diode laser en réponse au signal de moniteur électrique au moyen d'une première source de courant (8) commandée par ledit signal de moniteur électrique ;
   • une seconde boucle de commande adaptée pour commander la taille de la contribution de modulation du courant électrique à travers la diode laser en réponse au signal de moniteur électrique ; ; ladite seconde boucle de commande comportant un premier amplificateur (14), ledit signal de moniteur électrique étant connecté à une entrée dudit amplificateur ;

       **caractérisé en ce que**

   • le premier amplificateur (14) est un amplificateur de transimpédance ayant une faible impédance d'entrée ;
   • la première boucle de commande comprend en outre une source commandée en courant (7) ayant une entrée connectée au signal de moniteur électrique ; et
   • ladite première source de courant (8) est agencée pour être commandée par un signal de sortie provenant de la source commandée en courant (7).

2. Emetteur laser selon la revendication 1, **caractérisé en ce que** la source commandée en courant (7) est une source de courant commandée en courant.

3. Emetteur laser selon la revendication 2, **caractérisé en ce que** la source de courant commandée en courant (7) est un miroir de courant.

4. Emetteur laser selon la revendication 1, **caractérisé en ce que** le premier amplificateur de transimpédance (14) a un étage d'entrée du type émetteur mis à la masse.

5. Emetteur laser selon les revendications 1 à 4, **caractérisé en ce que** la première boucle de commande comporte un second amplificateur de transimpédance (4) connecté pour recevoir un signal de courant proportionnel au signal de moniteur électrique au moyen de la source de courant commandée en courant (7).

6. Emetteur laser selon la revendication 5, **caractérisé en ce que** la première boucle de commande comprend, en outre, un régulateur (6) connecté pour recevoir un signal provenant dudit premier amplificateur de transimpédance et pour émettre un signal de commande de polarisation qui peut être utilisé pour commander ladite diode laser.

7. Emetteur laser selon les revendications 1 à 6, **caractérisé en ce que** la seconde boucle de commande comporte un détecteur de valeur pic-à-pic (12) connecté pour recevoir un signal provenant dudit premier amplificateur de transimpédance.

8. Emetteur laser selon la revendication 7, **caractérisé en ce que** la seconde boucle de commande comprend en outre un régulateur (14) connecté pour recevoir un signal provenant dudit détecteur de valeur pic-à-pic et pour émettre un signal de commande de modulation qui peut être utilisé pour commander ladite diode laser.

9. Emetteur laser selon la revendication 1, **caractérisé en ce que** la source commandée en courant est une source de tension commandée en courant.

Fig. 1

Fig. 2

EP 1 042 875 B1

Fig. 3

Fig. 4

+V

→ LD

R51

DATA

$\overline{DATA}$

T51

T52

gm

T53

Fig. 5

G

Fig. 6

OP-5-K

OP25-K

OP85-K

P

Ip(-5C)

Ip(+25C)

P"1" (+25C)

Ip(+85C)

Pavg

P"0" (+25C)

IL

Ip_k    Ip_k    Ip_k

EP 1 042 875 B1

14